# EUROPEAN PATENT APPLICATION

(11) **EP 4 674 925 A1**
(43) Date of publication of application: **07.01.2026**
(21) Application number: 24185848.9
(22) Date of filing: 01.07.2024
(51) Int. Cl.: C09K 11/02, C09K 11/66

(54) **LUMINESCENT MATERIAL, DISPERSION, FILM, PHOTOELECTRIC DEVICE AND METHOD**

(71) Applicant: Helio Display Materials Limited, Headington Oxford OX3 8SB (GB)
(72) Inventor: SAKAI, Nobuya, Oxford OX3 8SB (GB); WENGER, Bernard, Oxford OX3 8SB (GB)
(74) Representative: Marks & Clerk LLP

(57) **Abstract**

A luminescent material comprises a perovskite crystal, a di(meth)acrylate compound of Formula 1 and an aminosilane compound or dispersant: 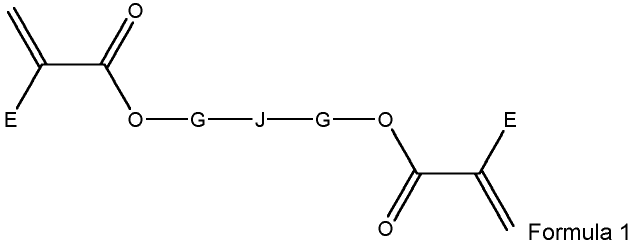 wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ')O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L⁵ is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.

## Description

### Introduction

The present invention relates to a luminescent material, a dispersion comprising the luminescent material, a film comprising the luminescent material, a photoelectric device or electroluminescent device, and a method of preparing a luminescent material.

### Background

Perovskite nanocrystals have garnered significant attention in the field of optoelectronics due to several advantages they offer over conventional semiconductors. Perovskite nanocrystals have demonstrated high photoluminescence quantum yields, a tunable band gap, solution processability, versatility, low temperature processing, and a large absorption coefficient. These advantages make perovskite nanocrystals ideal for applications such as colour converters, solar cells and light-emitting diodes (LEDs). While perovskite nanocrystals offer these advantages, improvements remain possible in areas such as efficiency, stability and scalability.

Efforts have been made to improve the technology using surface modifications using various dispersants and ligands. However, these have been observed to interfere with the performance of the nanocrystals for example by affecting the crystalline structure.

An object of the present invention is to provide a luminescent material that improves on the existing technology in the field of perovskite semiconductors.

### Summary of invention

According to a first aspect, the present invention provides a luminescent material comprising a perovskite crystal, a di(meth)acrylate compound of Formula 1 and an aminosilane compound: 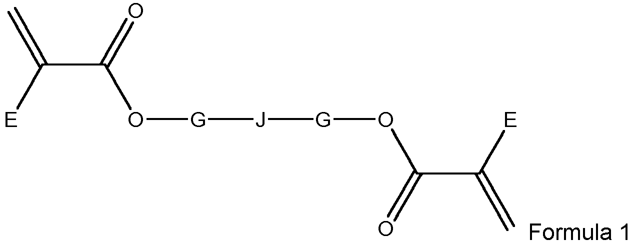
wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ¹)O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L⁵ is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.

According to a second aspect, the present invention provides a luminescent material comprising a perovskite crystal, a dispersant and a di(meth)acrylate compound of Formula 1: 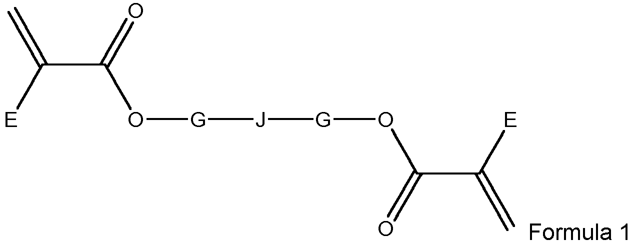
wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ¹)O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.

According to a third aspect, the present invention provides a film comprising the luminescent material according to the first aspect or the second aspect.

According to a third aspect, the present invention provides a photoelectric device or electroluminescent device comprising the film according to the second aspect.

According to a fourth aspect, the present invention provides a method of preparing a luminescent material according to the first aspect or the second aspect.

The inventors have found that when a perovskite crystal is formulated with a di(meth)acrylate compound of Formula 1, adverse effects associated with the formulating the perovskite crystal with a dispersant or an aminosilane compound are controlled, reduced or mitigated.

### Brief Description of the Drawings

FIG. 1 shows the PLQY (Left) and optical density (right) of CsPbBr₃ NCs film with the different amounts of APTES-BMEP at different annealing temperatures.
FIG. 2 shows the PLQY (Left Y axis) and optical density (right Y axis) of FAPbBr₃ NCs film with and without APTES-BMEP treatment at different annealing temperatures.
FIG. 3 shows the photoluminescence spectra of CsPb(IₓB₁₋ₓ)₃ NCs film without and with APTES-BMEP treatment after preparation on day 1 and day 4.
FIG. 4 shows the PLQY CsPb(IₓBr₁₋ₓ)₃ NCs film with and without pre-mixed APTES-BMEP treatments at different annealing temperatures.
FIG. 5 shows the photograph of NCs solution with various treatments.
FIG. 6 shows the PLQY, OD, Peak WL and FWHM of CsPb(IₓBr₁₋ₓ)₃ NCs film with various treatments at different annealing temperatures.
FIG. 7 shows the absorption spectra of CsPb(IₓB₁₋ₓ)₃ NCs film without and with tri-glycol amine-BMEP treatment.
FIG. 8 shows the absorption spectra of CsPb(IₓB₁₋ₓ)₃ NCs solution with the different amounts of dispersant (KD2 top, DISPERBYK-163 bottom)-BMEP.
FIG. 9 shows the PLQY, OD, Peak WL and FWHM of FAPbBr₃ NCs film with and without dispersant-BMEP-acrylate treatments at different annealing temperatures.
FIG. 10 shows the absorption spectra of FAPbBr₃ NCs solution with and without dispersant-BM EP-acrylate.

### Definitions

- NC: nanocrystal
- DiOPA: diisooctylphosphinic acid
- BTMSPA: bis[3-(trimethoxysilyl)propyl]amine
- BMEP: bis[2-(methacryloyloxy)ethyl] phosphate
- APTES: (3-Aminopropyl)triethoxysilane
- MPTMS: 3-Mercaptopropyl)trimethoxysilane
- PGMEA: propylene glycol methyl ether acetate
- XRF: X-ray fluorescence
- FA: formic acid
- Oc/OcA: octylamine
- UV: Ultraviolet
- AEAPTS: *N*-[3-(Trimethoxysilyl)propyl]ethylenediamine
- KD2: Hypermer KD2 available from Croda International Plc
- BYK2008: DISPERBYK-2008 available from BYK (Altana)

### Detailed description of the invention

The luminescent materials of the first aspect and the second aspect of the invention provide a solution to the problem of how to protect the perovskite surface from dispersants or ligands containing amine groups. Many commercial dispersants could not previously be used with perovskite crystals because they are amine-functionalised. It is believed that amines interfere with the performance of the nanocrystals for example, because an excess amount of amine and/or ammonium ions can affect the crystalline structure of the perovskite. The inventors found that when the perovskite crystal is formulated with a di(meth)acrylate compound of Formula 1, the perovskite crystal can be formulated with dispersants or ligands to enable the functionalisation of the perovskite crystals, for example by enhancing compatibility with a solvent and/or polymer matrix.

The inventors have therefore found a way to increase perovskite performance such as photoluminescence quantum yield, thermal stability and phase stability, particularly in dispersions. The luminescent materials of the first aspect and the second aspect therefore provide further freedom to functionalise the perovskite crystal by the use of previously unworkable ligands and dispersants in varying amounts.

Without wishing to be bound by theory, (meth)acrylate groups on the di(meth)acrylate compound of Formula 1 are hypothesised to react with the amine groups of the aminosilane compound or dispersants via an aza-Michael addition. This reaction "neutralises" the amine to prevent damaging the perovskite surface. Furthermore, siloxanes groups on the aminosilane compound can improve PLQY, phase and thermal stability of perovskite by forming a protecting silica shell upon hydrolysis and condensation. On the other hand, proton exchange can happen between the central co-ordinating J group on the di(meth)acrylate compound of Formula 1 (e.g. the phosphate group) and the amine of the aminosilane or the dispersant according to a conventional acid-base (e.g. carboxyl acid - amine) combination to passivate their ligand on perovskite surface. The di(meth)acrylate compound of Formula 1 is also expected to react with dispersants and/or acrylates preventing degradation of perovskite by the affinity group of the dispersants, whether it be amines or something else.

Since the luminescent material of the present invention can inhibit the reactivity of the amine groups of the aminosilane and/or dispersant with respect to the perovskite crystal, aminosilanes or dispersants that were previously thought to be incompatible and/or to adversely affect the properties of perovskite crystals can now be used with the perovskite crystal may improve the properties of the perovskite crystals.

In the following, references to the present invention refer to all aspects of the present invention unless specifically stated to the contrary.

The perovskite crystals of the present invention are preferably semiconducting perovskite nanocrystals.

In preferred embodiments of the invention, the luminescent material further comprises a (meth)acrylate compound. The presence of acrylate monomers is advantageous in terms of improving stability and dispersibility of the perovskite crystals.

In preferred embodiments of the invention, the perovskite crystal is organic metal halide perovskite material or a metal halide perovskite material.

The semiconducting perovskite may comprise an AMX₃ unit cell structure wherein A, M and X can be any suitable balancing combination of cationic and anionic species; and more preferably it is a metal halide perovskite material.

A preferred organic metal halide perovskite comprises an AMX₃ unit cell structure, where A is a monovalent cation, M is a divalent cation and X is a halide anion. In AMX₃, the following are preferred:
(i) M is a divalent metal cation;
(ii) the divalent metal cation M is tin (Sn²⁺) or lead (Pb²⁺);
(iii) the monovalent cation is a primary, secondary or tertiary ammonium cation [HNR¹R²R³]⁺, wherein each of R¹, R² and R³ may be the same or different and is selected from hydrogen, an unsubstituted or substituted C₁-C₂₀ alkyl group and an unsubstituted or substituted C₅-C₁₈ aryl group. Examples of suitable substituents for the alkyl groups are alkoxy groups having from 1 to 20 carbons atoms, hydroxyl groups, mono and dialkylamino groups wherein each alkyl group may be the same or different and has from 1 to 20 carbon atoms, cyano groups, nitro groups, thiol groups, sulphinyl groups, sulphonyl groups and aryl groups having from 5 to 18 carbon atoms. Examples of suitable substituents for the alkyl groups are alkyl groups having from 1 to 20 carbon atoms, alkenyl and alkynyl groups each having from 2 to 20 carbon atoms, alkoxy groups having from 1 to 20 carbons atoms, haloalkyl groups having from 1 to 20 carbon atoms, hydroxyl groups, mono and dialkylamino groups wherein each alkyl group may be the same or different and has from 1 to 20 carbon atoms, cyano groups, nitro groups, thiol groups, sulphinyl groups and sulphonyl groups;
(iv) the monovalent cation is of the form [R¹R²N-CH=NR³R⁴]⁺: 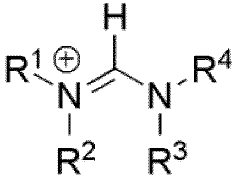 wherein each of R¹, R², R³ and R⁴ may be the same or different and is selected from hydrogen, an unsubstituted or substituted C₁-C₂₀ alkyl group and an unsubstituted or substituted C₅-C₁₈ aryl group. Examples of suitable substituents for the alkyl groups are alkyl groups having from 1 to 20 carbon atoms, alkenyl and alkynyl groups each having from 2 to 20 carbon atoms, alkoxy groups having from 1 to 20 carbons atoms, haloalkyl groups having from 1 to 20 carbon atoms, hydroxyl groups, mono and dialkylamino groups wherein each alkyl group may be the same or different and has from 1 to 20 carbon atoms, cyano groups, nitro groups, thiol groups, sulphinyl groups and sulphonyl groups;
(v) the monovalent cation is of the form (R¹R²N)(R³R⁴N)C=NR⁵R⁶: 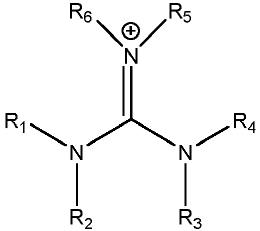 wherein each of R¹ R², R³, R⁴, R⁵ and R⁶ may be the same or different and is selected from hydrogen, an unsubstituted or substituted C₁-C₂₀ alkyl group and an unsubstituted or substituted C₅-C₁₈ aryl group. Examples of suitable substituents for the alkyl groups are alkyl groups having from 1 to 20 carbon atoms, alkenyl and alkynyl groups each having from 2 to 20 carbon atoms, alkoxy groups having from 1 to 20 carbons atoms, haloalkyl groups having from 1 to 20 carbon atoms, hydroxyl groups, mono and dialkylamino groups wherein each alkyl group may be the same or different and has from 1 to 20 carbon atoms, cyano groups, nitro groups, thiol groups, sulphinyl groups and sulphonyl groups;
(vi) the monovalent cation is an alkali metal cation;
(vii) the monovalent cation is caesium (Cs⁺) or rubidium (Rb⁺);
(viii) X is a halide anion selected from chloride, bromide, iodide, and fluoride and, in the AMX₃ unit cell structure each halide may be the same or different.

In another embodiment of the present invention, the preferred organic metal halide perovskite comprises an A₁₋ᵢBᵢMX₃ unit cell structure, wherein:
A and B are each a monovalent cation as defined above, where A and B are different;
M is a divalent metal cation as defined above;
X is a halide anion as defined above; and
i is between 0 and 1.

In a further embodiment of the present invention, the preferred organic metal halide perovskite material comprises an AMX₃₋ₖYₖ unit cell structure, wherein:
A is a monovalent cation as defined above;
M is a divalent metal cation as defined above;
X and Y are each a halide anion as defined above, where X and Y are different; and
k is between 0 and 3.

In a yet further embodiment of the present invention, the preferred organic metal halide perovskite material comprises an AM₁₋ⱼNⱼX₃ unit cell structure, wherein:
A is a monovalent cation as defined above;
M and N are each a divalent metal cation as defined above;
X is a halide anion as defined above; and
j is between 0 and 1.

In a further embodiment of the present invention, the preferred organic metal halide perovskite material comprises an A₁₋ᵢBᵢM₁₋ⱼNⱼX₃₋ₖYₖ unit cell structure, wherein:
A and B are each a monovalent cation as defined above, where A and B are different;
M and N are each a divalent metal cation as defined above;
X and Y are each a halide anion as defined above, where X and Y are different; and
where i is between 0 and 1, j is between 0 and 1, and k is between 0 and 3.

In preferred embodiments of the present invention, the aminosilane compound is a compound of Formula 2: 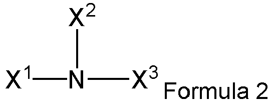
wherein X¹, X² and X³ are each independently H, C₁₋₁₀ alkyl, C₃-C₁₂ cycloalkyl, or Y, where at least one of X¹, X² and X³ is Y,
wherein Y is 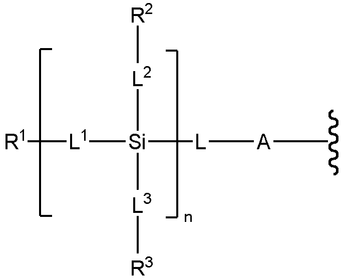
A is a branched or unbranched C₁-C₁₀ alkanediyl or C₃-C₁₂ cycloalkanediyl, optionally substituted with 1 to 3 R⁴;
each L, L¹, L² and L³ is independently selected from a covalent bond or O;
each R¹, R² and R³ is independently selected from the group consisting of H, branched or unbranched C₁-C₁₀ alkyl or C₃-C₁₂ cycloalkyl, each optionally substituted with 1 to 3 R⁴;
each R⁴ is independently selected from the group consisting of halogen, OH, SH, C₁-C₄ alkyl, C₂-C₄ alkenyl, or -[OCH₂CH₂-]ₘOR⁵,
   wherein n is an integer from 1 to 20 and m is an integer from 1 to 10, and
each R⁵ is independently selected from the group consisting of H, branched or unbranched C₁-C₁₀ alkyl or C₃-C₁₂ cycloalkyl and C₂-C₄ alkenyl.

For example, X¹, X² and X³ may each independently be selected from the group consisting from H, methyl, ethyl, propyl, isopropyl, butyl, isobutyl, sec-butyl, tert-butyl, pentyl, neopentyl, hexyl, isopentyl, heptyl, octyl, isobutyl, nonyl, decyl, cyclopropyl, cyclobutyl, cyclopentyl, cyclohexyl, cycloheptyl, cyclooctyl, cyclononyl, cyclodecyl, cycloundecyl, cyclododecyl, and Y. In preferred embodiments of the present invention, X¹ is H, C₁₋₁₀ alkyl or C₃-C₁₂ cycloalkyl. In particular, X¹ may be H or C₁₋₃ alkyl. In preferred embodiments of the present invention, X² is H, C₁₋₁₀ alkyl or C₃-C₁₂ cycloalkyl. In particular, X² may be H or C₁₋₃ alkyl.

For example, A may be selected from the group consisting of methanediyl, ethanediyl propanediyl, isopropanediyl, butanediyl, isobutanediyl, sec-butanediyl, tert-butanediyl, pentanediyl, neopentanediyl, hexanediyl, isopentanediyl, heptanediyl, octanediyl, isobutanediyl, nonanediyl, decanediyl, cyclopropanediyl, cyclobutanediyl, cyclopentanediyl, cyclohexanediyl, cycloheptanediyl, cyclooctanediyl, cyclononanediyl, cyclodecanediyl, cycloundecanediyl, cyclododecanediyl optionally substituted with 1 to 3 R⁴. In preferred embodiments of the present invention, A is a branched or unbranched C₁-C₆ alkanediyl.

In preferred embodiments of the present invention, L is a covalent bond. In preferred embodiments of the present invention, L¹, L² and L³ are each O.

Each R¹, R² and R³ may be independently selected from the group consisting of H, methyl, ethyl, propyl, isopropyl, butyl, isobutyl, sec-butyl, tert-butyl, pentyl, neopentyl, hexyl, isopentyl, heptyl, octyl, isobutyl, nonyl, decyl, cyclopropyl, cyclobutyl, cyclopentyl, cyclohexyl, cycloheptyl, cyclooctyl, cyclononyl, cyclodecyl, cycloundecyl, cyclododecyl, each optionally substituted with 1 to 3 R⁴. In preferred embodiments of the present invention, each R¹, R² and R³ is independently branched or unbranched C₁-C₆ alkyl.

n may be any integer from 1 to 20 (1, 2, 3, 4, 5, 6, 7, 8, 9, 10, 11, 12, 13, 14, 15, 16, 17, 18, 19 or 20) and m is an integer from 1 to 10 (1, 2, 3, 4, 5, 6, 7, 8, 9 or 10). In preferred embodiments of the present invention, n is 1 to 10, more preferably 1 to 5, 1 to 3, and most preferably 1.

In preferred embodiments of the present invention, the aminosilane compound may be selected from the group consisting of (3-aminopropyl)triethoxysilane (APTES), (3-aminopropyl)trimethoxysilane (APTMS), (3-aminopropyl)dimethylmethoxysilane, (3-aminopropyl)diethylmethoxysilane, (3-aminopropyl)dibutylmethoxysilane, (3-aminopropyl)dimethylethoxysilane and (3-aminopropyl)diphenyldimethoxysilane. In preferred embodiments, the aminosilane compound is APTES.

In preferred embodiments of the invention, the dispersant is selected from the group consisting of (3-mercaptopropyl)trimethoxysilane (MPTMS), (3-mercaptopropyl)methyldimethoxysilane, (3-mercaptopropyl)ethyltrimethoxysilane, (3-mercaptopropyl)propyltriethoxysilane, (3-mercaptopropyl)phenyltrimethoxysilane, (3-mercaptopropyl)dimethyldiethoxysilane, hexylamine, isopentylamine, heptylamine, octylamine, isobutylamine, nonylamine and decylamine. In preferred embodiments, the dispersant is MPTMS.

Each G is independently a branched or unbranched C₁-C₁₀ alkanediyl or C₃-C₁₂ cycloalkanediyl, optionally substituted with 1 to 3 L⁵. Each G may be independent selected from the group consisting of methanediyl, ethanediyl propanediyl, isopropanediyl, butanediyl, isobutanediyl, sec-butanediyl, tert-butanediyl, pentanediyl, neopentanediyl, hexanediyl, isopentanediyl, heptanediyl, octanediyl, isobutanediyl, nonanediyl, decanediyl, cyclopropanediyl, cyclobutanediyl, cyclopentanediyl, cyclohexanediyl, cycloheptanediyl, cyclooctanediyl, cyclononanediyl, cyclodecanediyl, cycloundecanediyl, cyclododecanediyl. In preferred embodiments, each G is independently a branched or unbranched C₁-C₆ alkanediyl, optionally substituted with 1 to 3 L⁵.

Each J may be independently selected from the group consisting of phosphate [OP(=O)(OQ¹)O], phosphonate [[OP(=O)(OQ¹)] carbonate [OC(=O)O], sulfonate [OS(=O)₂] or sulfate [OS(=O)₂O]. In preferred embodiments, J is phosphate [OP(=O)(OQ¹)O].

Each Q¹ may be independently selected from the group consisting of H, branched or unbranched C₁-C₁₀ alkyl or C₃-C₁₂ cycloalkyl and C₂-C₄ alkenyl. For example, each Q¹ may be independent selected from the group consisting of methyl, ethyl, propyl, isopropyl, butyl, isobutyl, sec-butyl, tert-butyl, pentyl, neopentyl, hexyl, isopentyl, heptyl, octyl, isobutyl, nonyl, decyl, cyclopropyl, cyclobutyl, cyclopentyl, cyclohexyl, cycloheptyl, cyclooctyl, cyclononyl, cyclodecyl, cycloundecyl, cyclododecyl, ethenediyl, propenediyl and butenediyl. Each Q¹ is preferably independently selected from the group consisting of H or C₁-C₆ alkyl.

In preferred embodiments of the present invention, the di(meth)acrylate compound of Formula 1 may be any selected from the group consisting of bis[2-(methacryloyloxy)ethyl] phosphate (BMEP), triethylene glycol dimethacrylate phosphate, bis[2-(methacryloyloxy)ethyl] sulfosuccinate, bis[2-(methacryloyloxy)ethyl] carbonate, bis[2-(methacryloyloxy)ethyl] maleate, bis[2-(methacryloyloxy)ethyl] ether and bis[2-(methacryloyloxy)ethyl] adipate. In particular preferred embodiments, the di(meth)acrylate compound of Formula 1 is BMEP.

In a most preferred embodiment, the luminescent material comprises a perovskite nanocrystal, APTES and BMEP. The nanocrystal is preferably a metal halide perovskite.

As used herein, a perovskite nanocrystal is a particle having at least one dimension of 200 nm or less, for example 100 nm or less, 80 nm or less, 60 nm or less, 40 nm or less or, 20 nm or less, 15 nm or less, 10 nm or less, 5 nm or less, 4 nm or less, 3 nm or less, 2 nm or less or 1 nm or less.

In certain embodiments, the perovskite crystal may be ligated by the di(meth)acrylate compound of Formula 1. The perovskite crystal may be associated with the (meth)acrylate compound of Formula 1 coordinatively, ionically or covalently. Optimally, the perovskite crystal is associated with the compound of Formula 1 ionically or coordinatively. In certain embodiments, the di(meth)acrylate compound of Formula 1 may be covalently bonded to the aminosilane. In certain embodiments, the perovskite crystal may be ligated by the di(meth)acrylate compound of Formula 1 and the di(meth)acrylate compound of Formula 1 may be covalently bonded to the aminosilane.

In preferred embodiments, the dispersant is a surfactant, e.g. a non-ionic surfactant, a cationic surfactant, a zwitterionic surfactant, an anionic surfactant, or a block copolymer.

Non-ionic surfactants according to the invention may include one or more selected from the group consisting of decyl glucoside, lauryl glucoside, polyethylene glycol (PEG)-7 glyceryl cocoate, polysorbate 20, polysorbate 80, sorbitan oleate, sorbitan stearate, PEG-40 hydrogenated castor oil, PEG-150 distearate, ceteth-20, steareth-20, ceteareth-20, laureth-23, PEG-100 stearate and ethoxylated alcohol.

Cationic surfactants according to the invention may include one or more selected from the group consisting of stearyl trimethyl ammonium chloride, cetyl trimethyl ammonium chloride, salts of oleylammonium, benzalkonium chloride, cetylpyridinium chloride, cetrimonium chloride, behentrimonium chloride, diethyl ester dimethyl ammonium chloride, dicocoylethyl hydroxyethylmonium methosulfate, behentrimonium methosulfate, cetrimonium bromide, cetylpyridinium bromide, lauryl pyridinium chloride, lauryl pyridinium bromide, hexadecylpyridinium chloride and octadecyltrimethylammonium bromide.

Zwitterionic surfactants according to the invention may include one or more selected from the group consisting of sulfobetaines, phosphocholines, phosphoethanolamines cocoamidopropyl betaine, lauramidopropyl betaine, cocamidopropyl hydroxysultaine, lauramidopropyl hydroxysultaine, lauryl betaine, cocamidopropylamine oxide, lauramidopropylamine oxide, cocamidopropyl hydroxysultaine, lauryl hydroxysultaine, cocamidopropyl PG-dimonium chloride phosphate, lauramidopropyl PG-dimonium chloride phosphate, cocamidopropyl betaine, lauramidopropyl betaine, coco betaine and lauryl betaine.

Anionic surfactants according to the invention may include one or more selected from the group consisting of sodium lauryl sulfate, sodium laureth sulfate, ammonium lauryl sulfate, ammonium laureth sulfate, sodium dodecylbenzenesulfonate, sodium cocoyl isethionate, sodium lauroyl sarcosinate, sodium methyl cocoyl taurate, sodium lauroyl lactylate, sodium cocoate, sodium oleate, sodium stearate, sodium palmitate, sodium myristate and sodium isethionate

Block copolymers useful as a dispersant according to the invention may include one or more selected from the group consisting of PEG-PPG-PEG, Pluronic F-68, Pluronic F-127, Pluronic P-123, Pluronic P-105, Tetronic 908, Tetronic 707, Tetronic 904, Tetronic 1107, Tetronic 1307, Plurafac RA-30, Plurafac D-25, Plurafac LF-403, Plurafac B-26 Plurafac A-38, DISPERBYK-163 (BYK), DISPERBYK-2000 (BYK), DISPERBYK-2008 (BYK), DISPERBYK-2014 (BYK), DISPERBYK-2050 (BYK), DISPERBYK-2061 (BYK), DISPERBYK-2117 (BYK), DISPERBYK-2118 (BYK), DISPERBYK-2150 (BYK), DISPERBYK-2155 (BYK), DISPERBYK-2157 (BYK), EFKA PX 4701 (BASF), and EFKA PX 4703 (BASF).

The present invention further provides a dispersion comprising:
a liquid dispersion medium,
a luminescent material according to any aspect or embodiment of the invention.

The dispersion medium in the liquid dispersion can vary depending on the specific application and properties desired, may preferably be selected from the group consisting of organic solvents such as ethanol, methanol, isopropanol, acetone, mineral oil, silicone oil, vegetable oils like olive oil, sunflower oil, glycerin, propylene glycol, ethylene glycol, polyethylene glycol (PEG), isopropyl myristate, hexane, heptane, octane, toluene, xylene, cyclohexane, dimethyl sulfoxide (DMSO) and chloroform.

The dispersion medium may be obtained by mixing a perovskite crystal, a compound of Formula 1 and an aminosilane compound or a dispersant in a liquid dispersion medium. The perovskite crystal, compound of Formula 1 and aminosilane compound or dispersant can be added in any particular order or together. For example, the liquid dispersion medium may be obtained by mixing the components together in any of the following orders:
- Perovskite crystal is added to the liquid dispersion medium first. The compound of Formula 1 is added to the liquid dispersion medium second. The aminosilane or dispersant is added to the liquid dispersion medium third.
- The compound of Formula 1 is added to the liquid dispersion medium first. Perovskite crystal is added to the liquid dispersion medium second. The aminosilane or dispersant is added to the liquid dispersion medium third.

- Perovskite crystal and the compound of Formula 1 are added to the liquid dispersion medium first. The aminosilane or dispersant is added to the liquid dispersion medium second.
- The compound of Formula 1 and the aminosilane or dispersant are added to the liquid dispersion medium first. Perovskite crystal is added to the liquid dispersion medium second.
- Perovskite crystal, the compound of Formula 1, and the aminosilane or dispersant are added to the liquid dispersion medium together.

Each component may be added to the liquid dispersion medium in its pure form or as a mixture with another substance, for example as a solution in a suitable solvent or a dispersion in a suitable dispersion medium.

A luminescent material may be obtained from the liquid dispersion by removing some or all of the liquid dispersion medium. The resulting luminescent material may be obtained by evaporating the liquid dispersion medium or filtering the luminescent material from the dispersion or by centrifugation. The luminescent material may be in a solid form. For example, the luminescent material may take the form of granules, powder or a film. In a preferred embodiment, the luminescent material is in the form of a film of the perovskite crystals. In a preferred embodiment, the luminescent material is obtained by spin-coating the liquid dispersion to obtain a film.

When provided as a film, preferably the luminescent material is provided as a thin film. A thin film may have a thickness of less than 50 µm; more preferably less than 10 µm, e.g. less than 5 µm. Typically, the film is 2-5 µm in thickness.

The luminescent material according to the invention may be incorporated into a photoelectric device or electroluminescent device. Accordingly, the present invention includes a photoelectric device or electroluminescent device comprising a film according to the invention.

A photoelectric device or electroluminescent device according to the invention preferably comprises, in order:
a first electrode coupled or not to a first charge injection layer;
an emissive layer comprising the luminescent material,
a second electrode coupled or not to a second charge injecting layer.

The photoelectric device or electroluminescent device may take any form known to be suitable in the art. For example, the photoelectric device or electroluminescent device may comprise a charge injecting layer provided between the first electrode and the emissive layer. The photoelectric device or electroluminescent device may comprise a charge injecting layer provided between the second electrode and the emissive layer.

A method of manufacturing a photoelectric device or electroluminescent device according to the present invention may include the steps of providing a first electrode on a substrate; depositing a first conducting layer over the first electrode; depositing a layer of the luminescent material according to the invention over the first conducting layer; depositing a second conducting layer over the luminescent material; and depositing a second electrode over the second conducting layer.

The photoelectric device or electroluminescent device may be incorporated into an electronic device, such as an electronic device comprising an LED display, a solar panel, or a photodetector.

The present invention also provides a method of preparing a luminescent material comprising perovskite crystal, a di(meth)acrylate compound of Formula 1, and an aminosilane compound comprising the step of:
contacting the perovskite crystal, a compound of Formula 1 and an aminosilane compound or a dispersant in a dispersion medium: 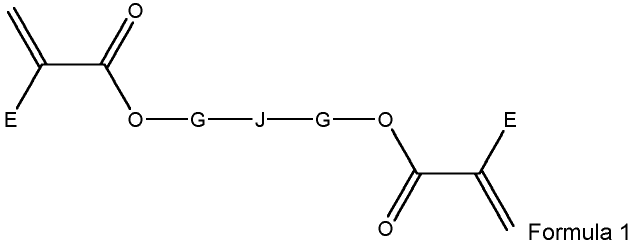
wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ¹)O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L⁵ is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.

In the method of preparing a luminescent material of the preceding paragraph, the perovskite crystal, compound of Formula 1, aminosilane compound, dispersant and dispersion medium are as described in the other aspects and embodiments of the invention.

### Examples

### Methods

The solutions and films were imaged with a digital camera. Photoluminescence spectra and photoluminescence quantum yields (PLQY) were measured with a calibrated integrated sphere using a fibre-coupled spectrometer (MayaPro, Ocean Optics) and a 450 nm laser diode for excitation (CPS450, Thorlabs). Absorption spectra of the perovskite NCs solution were measured in Quartz Glass Cuvettes with 10 mm Path Length with UV-vis spectrometer (UV-2600i, Shimadzu). Elemental analysis was carried out with XRF measurement (EDX-7200, Shimadzu). The obtained perovskite was dried on the Petri dish at 80 °C to make a powder sample. To remove excess ligands in the NCs solution, the obtained perovskite was washed with PGMEA twice and the washed perovskite was dried on the Petri dish at 80 °C to get the powder.

### CsPb(IₓBr₁₋ₓ)₃ Perovskite Synthesis

CsPb(I₁₋ₓBrₓ)₃ was prepared according to the method described in Kim, Min, et al. Chemistry of Materials 33.2 (2021): 547-553, the entirety of which is incorporated herein by reference. 0.1 mmol of lead (II) iodide, and 0.1 mmol of CsBr, were dissolved into 1 mL of N,N-dimethylformamide (DMF) and 0.1 mL of oleic acid and 0.05 mL of oleylamine were added into the DMF solution. 1 mL of the perovskite precursor in DMF was injected into 10 mL chlorobenzene and t-butyl alcohol (9:1 volume ratio) while stirring. A bright red precipitate appeared in the solution after injection. 30 mL of methoxy acetate was added into the solution holding the precipitate and mixed with a vortex mixer for 10-20 seconds. The precipitate was taken out by centrifuging at 7500 rpm for 3 min and washed with methoxy acetate: toluene (1:1 vol ratio), before being dispersed in toluene.

### CsPbBr₃ Perovskite Synthesis

CsPbBr₃ was prepared according to the method described in Li, Xiaoming, et al., Advanced Functional Materials 26.15 (2016): 2435-2445, the entirety of which is incorporated herein by reference. 0.4 mmol of CsBr and 0.4 mmol of lead (II) bromide, were dissolved in 10 mL of N,N-dimethylformamide and 1 mL of the solution was injected into 10 mL toluene containing 1 mL of oleic acid and 0.5 mL of oleylamine while stirring. A bright green precipitate appeared in the solution after injection. 30 mL of methoxy acetate was added into the solution holding the precipitate and mixed with a vortex mixer for 10-20 seconds. The precipitate was taken out by centrifuging at 7500 rpm for 3 min and washed with methoxy acetate: toluene (1:1 vol ratio), before being dispersed in toluene.

### FAPbBr₃ Perovskite Synthesis

FAPbBr₃ was prepared according to the method described in Levchuk, levgen, et al., Nano Letters 17.5 (2017): 2765-2770, the entirety of which is incorporated herein by reference. 0.1 mmol of Formamidine bromide and 0.1 mmol of lead (II) bromide were dissolved in 1 mL of N,N-dimethylformamide (DMF) and 0.2 mL of oleic acid and 0.04 mL of oleylamine were added into the DMF solution. 0.5 mL of the perovskite precursor in DMF was injected into 15 mL chloroform while stirring. A bright green precipitate appears in the solution after injection. 45 mL of methoxy acetate was added into the solution holding the precipitate and mixed with a vortex mixer for 10-20 seconds. The precipitate was taken out by centrifuging at 7500 rpm for 3 min and washed with methoxy acetate: toluene (1:1 vol ratio) a few times, before being dispersed in toluene.

### Example 1. APTES-BMEP treatment for green perovskite NCs

A dispersion of perovskite NCs (30 mg/mL) was stirred in a vial with a magnetic stir bar at 600 rpm. 50 wt% of BMEP solution was prepared in toluene. The BMEP solution was added to the perovskite NCs while stirring the solution. APTES was successively injected into the perovskite NCs solution. The solution was left under stirring for 1 h. The obtained perovskite was used for characterisation. Quantities of APTES, BMEP and NCs are shown in Table 1.

**Table 1**

| | Perovskite | NCs / mg | BMEP / µL | APTES / µL | PLQY (70°C anneal) | PLQY (180°C anneal) |
|---|---|---|---|---|---|---|
| Comparative Example 1-1 | CsPbBr₃ | 30 | 0 | 0 | 45% | 7% |
| Example 1-1 | CsPbBr₃ | 30 | 40 | 20 | 45% | 27% |
| Example 1-2 | CsPbBr₃ | 30 | 60 | 30 | 38% | 27% |
| Example 1-3 | FAPbBr₃ | 30 | 0 | 0 | 31% | 59% |
| Example 1-4 | FAPbBr₃ | 30 | 40 | 20 | 48% | 60% |

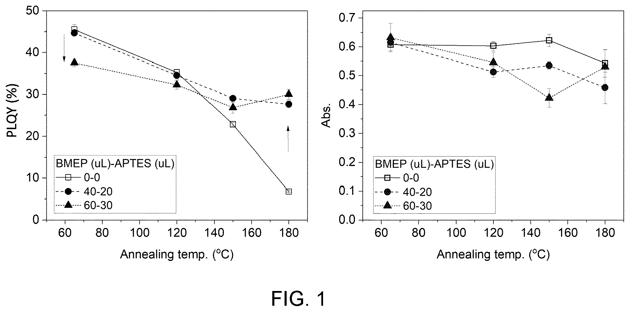

Fig. 1 shows the PLQY (left) and optical density (right) of a CsPbBr₃ NC film according to Examples 1-1 and 1-2 and Comparative Example 1-1 at different annealing temperatures (60 °C, 120 °C, 150 °C and 180 °C). At high annealing temperature (180 °C), the PLQY of Examples 1-1 and 1-2, including BMEP and APTES, had considerably higher PLQY than Comparative Example 1-1, lacking BMEP and APTES. At lower annealing temperatures, the PLQY of Examples 1-1 and Examples 1-2 and Comparative Example 1-1 were closer. It can therefore be said that the presence of APTES and BMEP stabilises the PLQY with respect to high annealing temperatures.

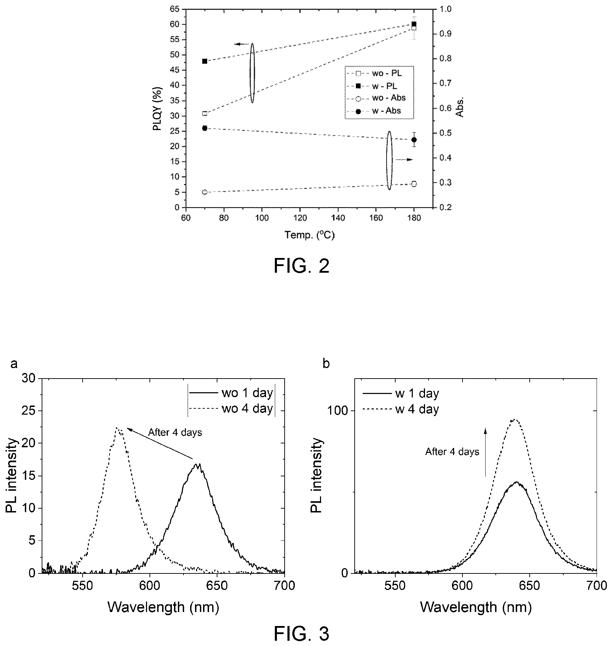

Fig. 2 shows the PLQY (left y-axis) and optical density (right y-axis) of FAPbBr₃ NCs according to Examples 1-3 and 1-4 and at different annealing temperatures. BMEP and APTES used in the mixing steps increases the PLQY at low annealing temperatures, and maintain high PLQY at high annealing temperature, demonstrating a passivation effect.

### Example 2. APTES-BMEP treatment for red perovskite NCs

A dispersion of CsPb(IₓB₁₋ₓ)₃ NCs (30 mg/mL) was stirred in a vial with a magnetic stir bar at 600 rpm. 50 wt% of BMEP solution was prepared in toluene. The BMEP solution was added to the perovskite NCs while stirring the solution. APTES was successively injected into the perovskite NCs solution. The solution was left under stirring for 1 h.

The obtained perovskite was used for characterisation. Quantities of APTES, BMEP and NCs are shown in Table 2.

**Table 2**

| | NCs / mg | BMEP / µL | APTES / µL |
|---|---|---|---|
| Comparative Example 2-1 | 30 | 60 | 30 |
| Example 2-1 | 30 | 20 | 10 |

PLQY, optical density, peak wavelength and full-width half maximum were determined for Example 2-1 and Comparative Example 2-1 after preparation at day 1 and day 4. The results are shown in Table 3 and confirm the improvement in PLQY with the use of APTES and BMEP (Example 2-1). Fig. 3 shows the PL spectrum. Comparative Example 2-1 shows a significant shift in peak wavelength between day 1 and day 4. Example 2-1 exhibits a more stable peak wavelength. This indicates that when using BMEP and APTES the spectral stability is also increased.

**Table 3**

| | | PLQY / % | OD / - | Peak WL / nm | FWHM / nm |
|---|---|---|---|---|---|
| Comparative Example 2-1 | Day 0 | 44 | 1.24 | 639 | 39.2 |
| | Day 4 | 67 | 1.27 | 639 | 36.6 |
| Example 2-1 | Day 0 | 11 | 1.12 | 634 | 36.7 |
| | Day 4 | 12 | 0.94 | 577 | 29.0 |

FIG. 3 shows the photoluminescence spectra of CsPb(IₓB₁₋ₓ)₃ NCs film with and without APTES-BMEP treatment after preparation on day 1 and day 4.

### Example 3. Pre-mixed APTES-BMEP

A dispersion of CsPb(IₓB₁₋ₓ)₃ NCs (30 mg/mL) was stirred in a vial with a magnetic stir bar at 600 rpm. 50 wt% of APTES-BMEP (1.8:1 molar ratio) solution was prepared in toluene. The APTES-BMEP solution was added to the perovskite NCs while stirring the solution. The solution was left under stirring for 1 h.

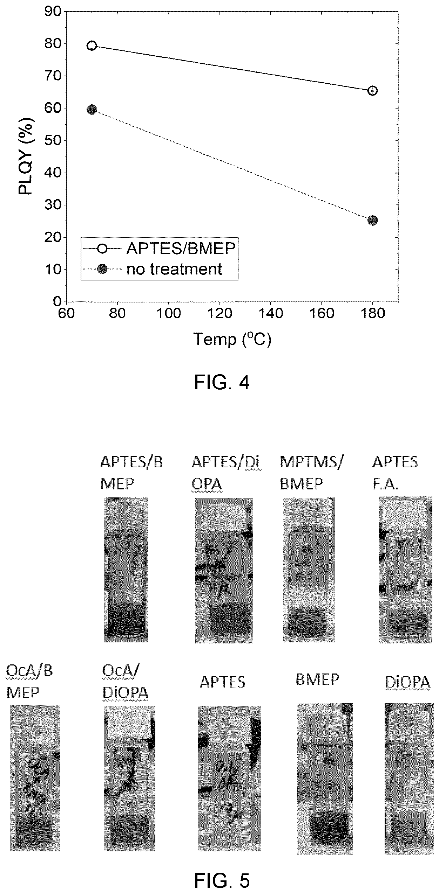

Fig. 4 shows the PLQY of CsPb(IₓBr₁₋ₓ)₃ NCs according to Examples 3-1 (APTES/BMEP; 70 °C) and 3-2 (APTES/BMEP; 180 °C) and Comparative Examples 3-1 (no treatment; 70 °C) and 3-2 (no treatment; 180 °C) at different annealing temperatures. Adding the APTES-BMEP mixture increases the PLQY significantly at both annealing temperatures and results in a smaller drop off in PLQY when increasing the annealing temperature, signifying higher thermal stability.

The effects shown in Example 3 and Fig. 4, where APTES and BMEP were pre-mixed, were similar to the effects shown in Examples 1 and 2 and Fig. 1a, where BMEP and APTES where added successively.

### Example 4. Comparison experiment with BMEP system for red perovskite NCs

The dispersion of red perovskite NCs was stirred in a vial with a magnetic stir bar at 600 rpm. Proton donor (DiOPA) was added to the perovskite NCs while stirring the solution. BMEP, DiOPA and FA were used as the proton donor. The proton acceptor or silane donor (APTES, octylamine, and MPTMS) was successively injected into the perovskite NCs solution. The ratio of the proton donor and the proton acceptor or silane donor was fixed in the same way as the APTES-BMEP system in Example 1-1. The solution was left under stirring for 1 h. The obtained perovskite was used for characterisation.

The following samples were prepared.

| | |
|---|---|
| Example 4-1 | APTES/BMEP |
| Example 4-2 | MPTMS/BMEP |
| Example 4-3 | OcA/BMEP |
| Comparative Example 4-1 | APTES/DiOPA |
| Comparative Example 4-2 | APTES/FA |
| Comparative Example 4-3 | OcA/DiOPA |
| Comparative Example 4-4 | APTES |
| Comparative Example 4-5 | BMEP |
| Comparative Example 4-6 | DiOPA |

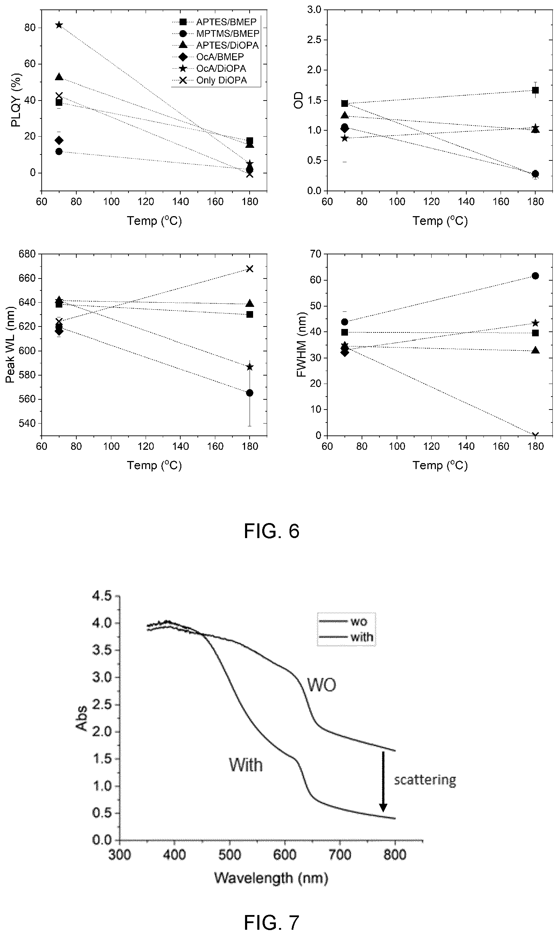

Photographs of Examples 4-1 to 4-3 and Comparative Examples 4-1 to 4-6 are shown in FIG. 5. The colour of the dispersions indicate that the combinations of a proton donor with a proton acceptor / silane donor results in bright photoluminescent dispersions (Examples 4-1 to 4-3 and Comparative Example 4-1 to 4-3). When only a proton acceptor/silane donor is present (Comparative Example 4-4) or only the proton donor is present (Comparative Examples 4-5 and 4-6), the perovskites are deteriorated and non-emissive. The PLQY, OD, Peak WL and FWHM of CsPb(IₓBr₁₋ₓ)₃ NCs film of Examples 4-1 to 4-3 and Comparative Examples 4-1, 4-3, 4-6 are shown in FIG. 6. While Comparative Example 4-3 shows high PLQE (80%) at the initial point, it has poor thermal stability, indicating that the silane moiety is required for thermal stability. In contrast, Example 4-1 demonstrates the highest thermal stability, with the highest PLQY and OD at 180 °C and a stable peak WL and FWHM. These examples illustrate that the invention is not limited to the APTES/BMEP system.

### Example 5. Tri-glycol amine-BMEP system as surfactant

50 wt% of BMEP solution was prepared in PGMEA. Trimethylolpropane tris[poly(propylene glycol), amine terminated] ether (Tri-glycol amine) and BMEP were mixed 1:2 molar ratio. 60 µL of Tri-glycol amine-BMEP mixture was added to 1 mL of perovskite NCs (30 mg/mL) in PGMEA. CsPb(IₓBr₁₋ₓ)₃ NCs in solution were dispersed by a sonication bath for 2 min. The obtained perovskite was used for characterisation.

Fig. 7 shows the absorption spectra of Example 5-1 (with tri-glycol amine) and Comparative Example 5-1 (without tri-glycol amine). The presence of tri-glycol amine and BMEP resulted in a good dispersion with low scattering in Example 5-1 compared with Comparative Example 5-1.

### Example 6. Dispersant-BMEP system as surfactant

Red perovskite NCs were dispersed in PGMEA (30 mg/mL). To 1 mL of perovskite solution was added a different dispersant system. NCs in solution were dispersed by a sonication bath for 2 min. The obtained perovskite was used for characterisation. The samples in Table 4 were prepared.

**Table 4**

| | **Dispersant system** | **Amount of dispersant system added / wt% of NC** |
|---|---|---|
| Comparative Example 6-1 (Control without dispersant or BMEP) | n/a | 0 |
| Comparative Example 6-2 | KD2 | 100 |
| Example 6-2-1 | KD2-BMEP (1:1 by weight) | 100 |
| Example 6-2-2 | KD2-BMEP (1:1 by weight) | 500 |
| Comparative Example 6-3 | Disperbyk-163 | 100 |
| Example 6-3-1 | Disperbyk-163-BM EP (1:1 by weight) | 100 |
| Example 6-3-2 | Disperbyk-163-BM EP (1:1 by weight) | 500 |
| Comparative Example 6-4 | BYK2008 | 100 |
| Examples 6-4-1 | Disperbyk-163-BM EP (1:1 by weight) | 100 |

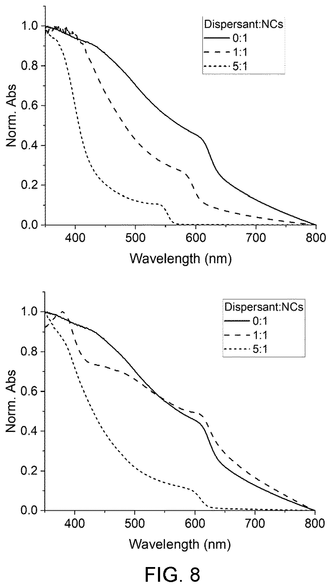

The absorption spectra of Comparative Example 6-1 (no dispersant system), Examples 6-2-1 and 6-2-2 (with KD2-BMEP) and Examples 6-3-1, and 6-3-2 (with BYK-BMEP) are shown in FIG. 8. The presence of dispersant and BMEP resulted in a good dispersion with low scattering in Examples 6-2-1, 6-2-2, 6-3-1 and 6-3-2. Examples 6-3-1 and 6-3-2 exhibited decreased scattering without blue shift of optical band gap of NCs, even when the dispersant-BMEP was added in an amount by weight that was 5 times higher than the amount of the NCs by weight. The natural display colour of certain examples are shown in Table 6.

The PLQY values for Comparative Example 6-1, Comparative Example 6-2 and Example 6-2-1 are shown in Table 5.

**Table 5**

| | PLQY / % |
|---|---|
| Comparative Example 6-1 | 31 |
| Comparative Example 6-2 | 9 |
| Example 6-2-1 | 22 |

The results in Table 5 show that in the absence of BMEP, the addition of KD2 to the perovskite significantly worsens the PLQY. BMEP protects the perovskite from KD2.

**Table 6**

| | R | G | B |
|---|---|---|---|
| Comparative Example 6-1 | 225 | 33 | 55 |
| Comparative Example 6-2 | 212 | 49 | 40 |
| Example 6-2-1 | 160 | 23 | 35 |
| Comparative Example 6-3 | 236 | 162 | 43 |
| Example 6-3-1 | 168 | 23 | 31 |

In the absence of BMEP, KD2 and BYK2008 show a very large blue shift immediately, indicating a strong degradation of the perovskite NCs. The addition of BMEP in the presence of the dispersant prevents the blue shift.

### Example 7. Dispersant-BMEP-acrylate system as surfactant

Solsperse 71000 (Solsperse), Photomer 4127 (IGM resin) and BMEP were mixed as 1: 0.66: 3.34 as a weight ratio to prepare Dispersant-BMEP-acrylate system. The perovskite NCs were washed with PGMEA twice and centrifuged at 7500 rpm for 3 min after each washing process. The centrifuged NCs (-0.4g as dried weight - used as Comparative Example 7) were transferred to a ball milling jar. 15 g of Zr balls (2 mm), 0.06 g (15 wt% to the weight of perovskite NCs) of the prepared dispersant mix and the additional PGMEA up to 4.0 parts to perovskite NCs were added to the jar to provide the NCs treated with the dispersant-BMEP-acrylate system (Example 7). Milling was carried out at 150 rpm for 60 min (4 cycles 15 min each, with 5 min pauses). The milled NCs were taken out from the jar. The obtained perovskite was used for characterisation.

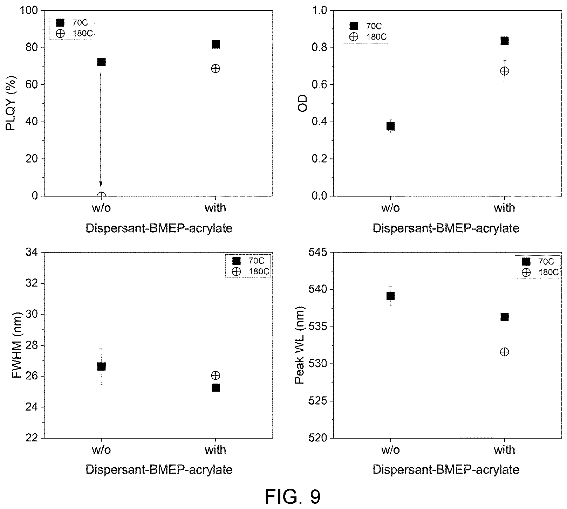

FIG. 9 shows the PLQY, OD, Peak WL and FWHM of FAPbBr₃ NCs film with and without dispersant-BMEP-acrylate treatments at different annealing temperatures.

Example 7 exhibits significantly greater thermal stability, with lower reduction in PLQY on annealing at high temperatures in comparison with Comparative Example 7. FIG. 9 also shows that Example 7 has higher initial and final optical density. The presence of dispersant-BMEP improves dispersibility.

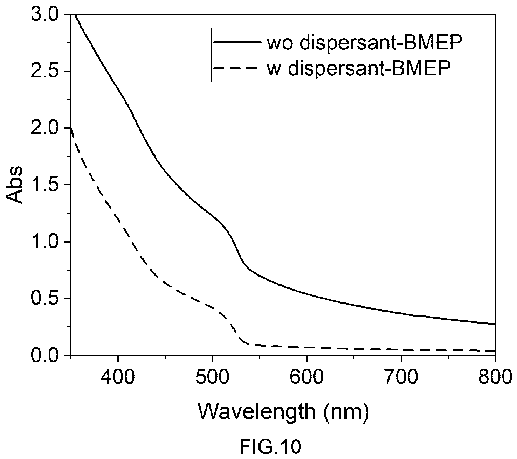

FIG. 10 shows the absorption spectra of FAPbBr₃ NCs solution with and without dispersant-BMEP-acrylate, illustrating a strong reduction in scattering with the dispersant-BMEP-acrylate system.

## Claims

1. A luminescent material comprising a perovskite crystal, a di(meth)acrylate compound of Formula 1 and an aminosilane compound: 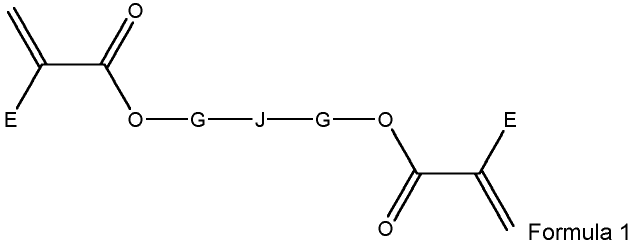
wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ¹)O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L⁵ is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.

2. A luminescent material comprising a perovskite crystal, a dispersant and a di(meth)acrylate compound of Formula 1: 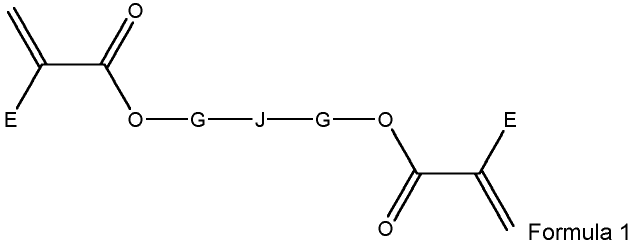
wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ¹)O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.

3. A luminescent material according to claim 1 or 2, further comprising:
a (meth)acrylate compound.

4. A luminescent material according to any of claims 1 to 3, wherein the perovskite crystal is organic metal halide perovskite material or a metal halide perovskite material.

5. A luminescent material according to any of claims 1 to 4, wherein the aminosilane compound is a compound of Formula 2: 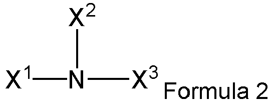
wherein X¹, X² and X³ are each independently H, C₁₋₁₀ alkyl, C₃-C₁₂ cycloalkyl, or Y, where at least one of X¹, X² and X³ is Y,
wherein Y is 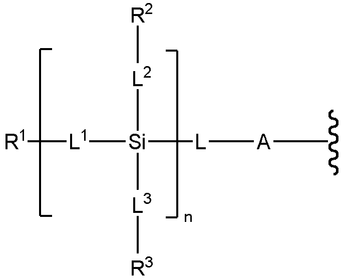
A is a branched or unbranched C₁-C₁₀ alkanediyl or C₃-C₁₂ cycloalkanediyl, optionally substituted with 1 to 3 R⁴;
each L, L¹, L² and L³ is independently selected from a covalent bond or O;
each R¹, R² and R³ is independently selected from the group consisting of H, branched or unbranched C₁-C₁₀ alkyl or C₃-C₁₂ cycloalkyl, each optionally substituted with 1 to 3 R⁴;
each R⁴ is independently selected from the group consisting of halogen, OH, SH, C₁-C₄ alkyl, C₂-C₄ alkenyl, or -[OCH₂CH₂-]ₘOR⁵,
wherein n is an integer from 1 to 20 and m is an integer from 1 to 10, and
each R⁵ is independently selected from the group consisting of H, branched or unbranched C₁-C₁₀ alkyl or C₃-C₁₂ cycloalkyl and C₂-C₄ alkenyl.

6. A luminescent material according to claim 5,
wherein X¹ is H, C₁₋₁₀ alkyl or C₃-C₁₂ cycloalkyl, preferably wherein X¹ is H or C₁₋₃ alkyl; and/or
wherein X² is H, C₁₋₁₀ alkyl or C₃-C₁₂ cycloalkyl, preferably wherein X² is H or C₁₋₃ alkyl; and/or
wherein A is a branched or unbranched C₁-C₆ alkanediyl; and/or
wherein L is a covalent bond; and/or
wherein L¹, L² and L³ are each O; and/or
wherein each R¹, R² and R³ is independently branched or unbranched C₁-C₆ alkyl; and/or
wherein n is 1.

7. A luminescent material according to any of claims 1 to 6, wherein each G is independently a branched or unbranched C₁-C₆ alkanediyl, optionally substituted with 1 to 3 L⁵; and/or
wherein J is phosphate [OP(=O)(OQ')O]; and/or
wherein Q¹ is independently selected from the group consisting of H or C₁-C₆ alkyl; and/or

8. A luminescent material according to claims 1 to 7, wherein the aminosilane compound is (3-aminopropyl)triethoxysilane (APTES); and/or
wherein the di(meth)acrylate compound of Formula 1 is bis[2-(methacryloyloxy)ethyl] phosphate (BMEP).

9. A luminescent material according to any of claims 1 to 8, wherein the perovskite crystal is ligated by the di(meth)acrylate compound of Formula 1; and/or wherein the di(meth)acrylate compound of Formula 1 is covalently bonded to the aminosilane.

10. A luminescent material according to any of claims 1 to 9, wherein the dispersant is a surfactant, e.g. a non-ionic surfactant, a cationic surfactant, a zwitterionic surfactant, an anionic surfactant, or a block copolymer.

11. A dispersion comprising:
a liquid dispersion medium,
a luminescent material according to any of claims 1 to 10.

12. A luminescent material obtained from the dispersion of claim 11 by removing some or all of the liquid dispersion medium; optionally wherein the liquid dispersion medium is removed by drying or filtering.

13. A film comprising the luminescent material according to any of claims 1 to 10 or 12.

14. A photoelectric device or electroluminescent device comprising the film according to claim 13, optionally comprising, in order:
a first electrode;
an emissive layer comprising the luminescent material,
a second electrode.

15. A method of preparing a luminescent material comprising perovskite crystal, a di(meth)acrylate compound of Formula 1, and an aminosilane compound comprising the step of:
contacting the perovskite crystal, a compound of Formula 1 and an aminosilane compound in a dispersion medium: 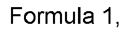 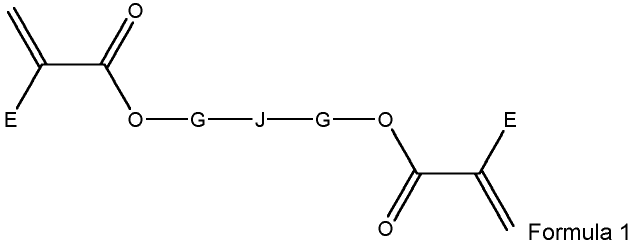
wherein each E is independently H or CH₃;
each G is independently a branched or unbranched C₁-C₁₀ alkanediyl or C₃-C₁₂ cycloalkanediyl, optionally substituted with 1 to 3 L⁵;
J is phosphate [OP(=O)(OQ¹)O], phosphonate [[OP(=O)(OQ¹)] carbonate [OC(=O)O], sulfonate [OS(=O)₂] or sulfate [OS(=O)₂O]; wherein Q¹ is independently selected from the group consisting of H, branched or unbranched C₁-C₁₀ alkyl or C₃-C₁₂ cycloalkyl and C₂-C₄ alkenyl;
each L⁵ is independently selected from the group consisting of halogen, OH, SH, C₁-C₄ alkyl, C₂-C₄ alkenyl, or -[OCH₂CH₂-]ₙOQ²;
wherein n is an integer from 1 to 10, and
each Q² is independently selected from the group consisting of H, branched or unbranched C₁-C₁₀ alkyl or C₃-C₁₂ cycloalkyl and C₂-C₄ alkenyl.
